(19) Europäisches Patentamt / European Patent Office / Office européen des brevets

(11) **EP 4 575 411 B1**

(12) **FASCICULE DE BREVET EUROPEEN**

(45) Date de publication et mention
de la délivrance du brevet:
**18.03.2026 Bulletin 2026/12**

(21) Numéro de dépôt: **24218076.8**

(22) Date de dépôt: **06.12.2024**

(51) Classification Internationale des Brevets (IPC):
**G01D 4/00** *(2006.01)*    **H04L 69/04** *(2022.01)*
**H03M 7/48** *(2006.01)*    **G06Q 30/0283** *(2023.01)*
**G06Q 30/04** *(2012.01)*    **G06Q 50/06** *(2024.01)*

(52) Classification Coopérative des Brevets (CPC):
**G01D 4/002; G06Q 30/0283; G06Q 30/04;
G06Q 50/06; H03M 7/48; H04L 69/04**

(54) **COMPRESSION ADAPTATIVE DE TRAMES DE COLLECTE**

ADAPTIVE KOMPRIMIERUNG VON SAMMELRAHMEN

ADAPTIVE COMPRESSION OF COLLECTION FRAMES

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **18.12.2023 FR 2314409**

(43) Date de publication de la demande:
**25.06.2025 Bulletin 2025/26**

(73) Titulaire: **SAGEMCOM ENERGY & TELECOM SAS
92270 Bois-Colombes (FR)**

(72) Inventeurs:
• **ABID, Oussama**
**92270 BOIS-COLOMBES (FR)**
• **SABRAOUI, Abbas**
**92270 BOIS-COLOMBES (FR)**
• **BASTURK, Ahmet Samed**
**92270 BOIS-COLOMBES (FR)**

(74) Mandataire: **Cabinet Boettcher
5, rue de Vienne
75008 Paris (FR)**

(56) Documents cités:
**FR-A1- 3 113 219**

• **JULIEN SPIEGEL: "A Comparative Experimental
Study of Lossless Compression Algorithms for
Enhancing Energy Efficiency in Smart Meters",
2018 IEEE 16TH INTERNATIONAL CONFERENCE
ON INDUSTRIAL INFORMATICS (INDIN), July
2018 (2018-07-01), pages 447 - 452,
XP093169918, ISBN: 978-1-5386-4829-2, DOI:
10.1109/INDIN.2018.8471921**
• **SPIEGEL JULIEN ET AL: "Energy ef ciency
optimization in uid ow metering", 2018, pages
1940 - 1945, XP093170136, Retrieved from the
Internet <URL:https://ieeexplore.ieee.org/
stampPDF/getPDF.jsp?tp=&arnumber=8352483&
ref=aHR0cHM6Ly9pZWVleHBsb3JlLmllZ
WUub3JnL2RvY3VtZW50LzgzNTI0ODM=>
[retrieved on 20240604]**

EP 4 575 411 B1

**Description**

L'invention concerne le domaine des compteurs communicants : compteurs d'eau, de gaz, d'électricité, etc.

ARRIERE PLAN DE L'INVENTION

Les compteurs d'eau modernes, aussi appelés « compteurs d'eau communicants », comprennent bien sûr une unité de mesure destinée à mesurer la consommation d'eau d'une installation, mais aussi une unité de traitement et une unité de communication.

L'unité de traitement acquiert les mesures et permet au compteur d'eau de réaliser un certain nombre de fonctionnalités, et notamment d'analyser des données diverses, relatives par exemple à la consommation d'eau de l'installation, à la facturation du client, à l'état du réseau de distribution d'eau, ou bien au fonctionnement du compteur d'eau lui-même.

L'unité de communication permet d'intégrer le compteur dans un réseau de communication, par exemple de type LPWAN (pour *Low Power Wide Area Network*, ou réseau étendu à basse consommation), et de communiquer avec d'autres entités du réseau, et notamment avec le Système d'Information (SI) du fournisseur d'eau, éventuellement via un concentrateur de données, une passerelle, ou bien un autre compteur (tel qu'un compteur d'eau communicant de quartier).

Chaque jour, un compteur d'eau transmet au SI au moins une trame de collecte contenant des index de consommation d'eau de l'installation à laquelle est raccordé le compteur.

La fonction de télétransmission des index de consommation est primordiale car elle permet une meilleure gestion de l'eau. Les fournisseurs d'eau s'en servent pour facturer les clients, pour suivre la consommation d'eau afin de détecter les fuites d'eau, les utilisations excessives et les problèmes potentiels. Les fournisseurs d'eau peuvent également ajuster la production et la distribution d'eau en temps réel en fonction de la demande, ce qui peut aider à réduire les gaspillages et à optimiser les ressources.

Chaque jour est donc découpé en intervalles temporels.

Chaque trame de collecte, produite par l'unité de traitement et transmise par l'unité de communication, est par exemple semblable à celle représentée dans le tableau de l'Annexe 1. Le protocole utilisé pour la communication est par exemple le protocole DLMS ou le protocole M-bus. La trame de collecte contient, pour chaque intervalle temporel, une donnée de mesure (index de consommation). On voit que dans cette trame de collecte, chaque intervalle temporel a une durée de 5 minutes, et que la donnée de mesure est l'index cumulé (en litres). Dans un jour, il y a (24h * 60min) / 5 min = 288 intervalles temporels. Chaque donnée de mesure a une taille de 4 octets, de sorte que la taille de la trame de collecte est d'au moins 288 x 4 octets = 1152 octets. La taille de la trame de collecte est en général plus importante encore. En effet, il est possible par exemple que des champs de contrôle soient présents pour indiquer le nombre d'index, l'heure de départ du premier index et l'intervalle en heures entre les index. Dans un souci de simplicité, ces champs de contrôle ont été volontairement omis.

Plus le pas de collecte (durée d'un intervalle temporel) est faible, plus le fournisseur d'eau arrive à gérer le réseau de manière optimale, à détecter efficacement les fuites et à optimiser la distribution d'eau. En effet, une résolution fine des données permet une meilleure précision dans la détection des anomalies et des variations de consommation, ce qui facilite la mise en place de mesures pour réduire les pertes d'eau et améliorer l'efficacité du réseau.

Cependant, réduire le pas de collecte augmente automatiquement la taille des trames de collecte.

Or, on sait que les différents composants électroniques du compteur d'eau sont alimentés par une ou des piles positionnées dans le compteur. Il convient donc de limiter la consommation électrique des composants électroniques du compteur d'eau, pour augmenter la durée de vie de celui-ci. La transmission sans fil des données de consommation a un impact significatif sur la consommation énergétique du compteur. Il est important de limiter la consommation électrique de l'unité de communication en particulier, ce qui contraint les fabricants à augmenter la durée des intervalles temporels de la trame de collecte pour réduire sa taille, et à perdre ainsi en résolution.

Par ailleurs, des trames de collecte plus longues nécessitent plus de temps pour être transmises, ce qui augmente l'encombrement du réseau de communication et le risque de perte de trames (ce qui oblige à retransmettre les trames, et augmente donc encore l'encombrement).

Ainsi, bien qu'une résolution fine du pas de collecte soit très avantageuse, cela implique une taille de trames de collecte importante et impacte négativement la consommation électrique du compteur et la congestion du réseau de communication.

Spiegel Julien et al, "A Comparative Experimental Study of Lossless Compression Algorithms for Enhancing Energy Efficiency in Smart Meters", 2018 IEEE 16TH International Conference on Industrial Informatics(INDIN), juillet 2018, pages 447-452, est un article scientifique qui discute plusieurs méthodes connues de compression de données pour la transmission de données de consommation d'un compteur, et propose une méthode particulière améliorée. Parmi les méthodes bien connues, le codage différentiel (differential coding) est basé sur le calcul de différences entre des données de consommation successives. Une autre méthode bien connue, le "Run-Length Encoding" (RLE) comprend le remplacement de données successives identiques par une description du nombre d'occurrences de telles données successives identiques et de la donnée correspondante. Cet article propose enfin une méthode "Run-Length Binary Encoding"(RLBE) combinant plusieurs étapes successives correspondant à de telles méthodes connues.

FR 3 113 219 A1 divulgue un procédé de transmission de mesures réalisées par un compteur de fluide au cours de périodes de mesure successives découpées chacune en intervalles temporels successifs, les mesures comprenant des premières mesures représentatives chacune d'une quantité de fluide distribuée au cours de l'un des intervalles temporels, le procédé de transmission comprenant l'étape, pour chaque période de mesure, de produire puis de transmettre au moins une trame de mesure telle que : si, au cours de ladite période de mesure, un nombre de premières mesures nulles est strictement inférieur à un nombre prédéterminé, alors la trame de mesure est une trame de mesure normale comportant des premières données de mesure normales comprenant toutes les premières mesures de ladite période de mesure ; sinon, la trame de mesure est une trame de mesure compacte qui comprend, si au moins une première mesure n'est pas nulle : des données préliminaires qui comprennent des données d'identification d'intervalles temporels actifs de ladite période de mesure, qui sont associés à des premières mesures non nulles ; des premières données de mesures compactes comprenant uniquement lesdites premières mesures non nulles, ordonnées selon un ordre prédéfini.

## OBJET DE L'INVENTION

L'invention a pour objet une solution permettant de réduire la taille des trames de collecte transmises par un compteur, sans réduire la résolution des mesures transmises.

## RESUME DE L'INVENTION

En vue de la réalisation de ce but, on propose un procédé de transmission de mesures, mis en œuvre dans une unité de traitement d'un compteur agencé pour mesurer une grandeur consommée par une installation au cours de périodes de mesure successives, comprenant les étapes, pour chaque période de mesure, de :

- découper ladite période de mesure en intervalles temporels ;
- associer une donnée de mesure à chaque intervalle temporel, ladite donnée de mesure étant représentative d'une consommation par l'installation de la grandeur au cours dudit intervalle temporel ;
- détecter, dans ladite période de mesure, au moins une période de consommation constante formée par des intervalles temporels successifs au cours de chacun desquels la consommation est égale à une valeur constante ;
- produire et transmettre une trame de collecte contenant les données de mesure associées aux intervalles temporels de la période de mesure, en remplaçant, pour chaque période de consommation constante, les données de mesure associées aux intervalles temporels successifs de ladite période de consommation constante par des données compactées comprenant au moins une première donnée permettant d'identifier lesdits intervalles temporels successifs de ladite période de consommation constante et une deuxième donnée contenant la valeur constante correspondant à ladite période de consommation constante.

En se basant sur la consommation d'eau habituelle des ménages, on a constaté qu'une journée « normale » comprend un certain nombre de périodes de consommation constante. Ces périodes correspondent généralement à des moments où l'eau n'est pas consommée, par exemple le soir ou pendant les heures de travail. Cela peut correspondre aussi à des débits de petites fuites constantes dans le temps.

L'existence de ces périodes de consommation constante peut être constatée pour toute grandeur mesurée par tout type de compteur : compteur de gaz, d'électricité, etc.

Le procédé de transmission de mesures consiste donc à détecter ces périodes de consommation constante dans chaque période de mesure, et à compacter dans la trame de collecte les données de mesures associées aux intervalles temporels desdites périodes de consommation constante. On obtient donc une trame de collecte de taille réduite sans pour autant réduire la résolution des données transmises.

On propose de plus un procédé de transmission de mesures tel que précédemment décrit, comprenant l'étape de vérifier, pour chaque période de consommation constante, qu'une taille des données compactées est inférieure à une taille des données de mesure associées aux intervalles temporels successifs de ladite période de consommation constante, et d'effectuer le remplacement des données de mesure par les données compactées seulement si c'est le cas.

On propose de plus un procédé de transmission de mesures tel que précédemment décrit, comprenant en outre l'étape, pour chaque période de mesure, de définir une durée optimale des intervalles temporels, la durée optimale étant la plus petite durée qui permet de conserver une taille de la trame de collecte inférieure ou égale à une taille maximale prédéfinie, ladite période de mesure étant ensuite découpée en intervalles temporels ayant pour durée la durée optimale.

On propose de plus un procédé de transmission de mesures tel que précédemment décrit, comprenant en outre l'étape d'allouer, à chaque donnée de mesure, une même taille de donnée obtenue à partir d'une valeur maximale des données de mesure sur ladite période de mesure.

On propose de plus un procédé de transmission de mesures tel que précédemment décrit, dans lequel, pour chaque intervalle temporel, la donnée de mesure est égale à la consommation par l'installation de la grandeur au cours dudit intervalle temporel.

On propose de plus un compteur comprenant une unité de communication et une unité de traitement dans laquelle est mis en œuvre le procédé de transmission de mesures tel que précédemment décrit, l'unité de communication étant agencée pour transmettre les trames de collecte à une entité externe au compteur.

On propose de plus un compteur tel que précédemment décrit, le compteur étant un compteur de fluide.

On propose de plus un programme d'ordinateur comprenant des instructions qui conduisent l'unité de traitement du compteur tel que précédemment décrit à exécuter les étapes du procédé de transmission de mesures tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés parmi lesquels :

[Fig. 1] la figure 1 représente un compteur d'eau, un réseau de distribution et une installation alimentée par ledit réseau ;
[Fig. 2] la figure 2 représente un graphique comprenant une courbe de la consommation journalière d'eau d'un appartement ;
[Fig. 3] la figure 3 représente les étapes d'un processus de définition de la durée optimale des intervalles temporels ;
[Fig. 4] la figure 4 représente les étapes d'un processus de calcul de la taille d'une trame de collecte.

DESCRIPTION DETAILLEE DE L'INVENTION

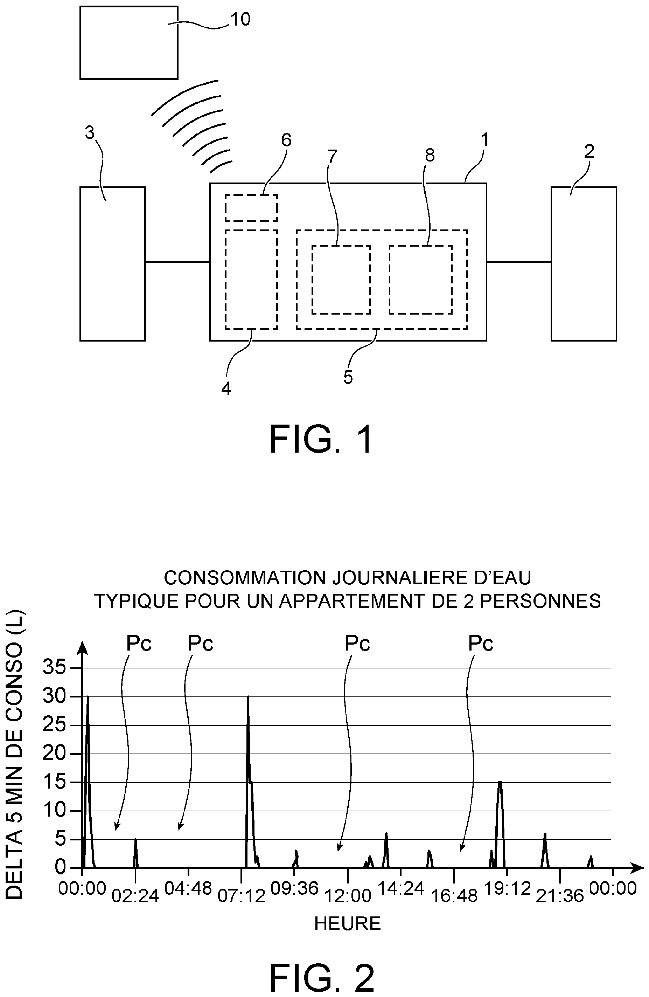

En référence à la figure 1, un compteur d'eau 1 est utilisé pour mesurer le volume d'eau consommé par une installation 2. L'eau est fournie à l'installation 2 par un réseau de distribution d'eau 3.

Le compteur 1 comporte une unité de mesure 4, une unité de traitement 5 et une unité de communication 6.

L'unité de mesure 4 comprend par exemple un dispositif de mesure ultrasonique qui permet d'estimer le débit d'eau consommé et donc le volume d'eau consommé.

L'unité de traitement 5 est une unité électronique et logicielle. L'unité de traitement 5 comprend au moins un composant de traitement 7, qui est par exemple un processeur « généraliste », un processeur spécialisé dans le traitement du signal (ou DSP, pour *Digital Signal Processor*), un processeur spécialisé pour les algorithmes d'intelligence artificielle (de type NPU, pour *Neural Processing Unit*), un microcontrôleur, ou bien un circuit logique programmable tel qu'un FPGA (pour *Field Programmable Gate Arrays*) ou un ASIC (pour *Application Specific Integrated Circuit*).

L'unité de traitement 5 comprend aussi une ou des mémoires 8, reliées à ou intégrées dans le composant de traitement 7. Au moins l'une de ces mémoires 8 forme un support d'enregistrement lisible par ordinateur, sur lequel est enregistré au moins un programme d'ordinateur comprenant des instructions qui conduisent l'unité de traitement 5 à exécuter au moins certaines des étapes du procédé de transmission de mesures qui va être décrit.

L'unité de traitement 5 met en œuvre un certain nombre de fonctionnalités. Parmi celles-ci, l'unité de traitement 5 acquiert les mesures réalisées par l'unité de mesure 4, traite et met en forme lesdites mesures, et produit des trames de collecte à partir de ces mesures. Les trames de collecte sont alors transmises au SI 10 par l'unité de communication 6.

Le compteur 1 mesure donc le volume d'eau consommé par l'installation 2 au cours de périodes de mesure successives.

Les périodes de mesure ont ici chacune pour durée un jour, c'est-à-dire 24 heures, et débutent à 00h00 (00 :00) pour s'achever à 23h59 (23 :59).

Après chaque période de mesure, l'unité de traitement 5 produit une trame de collecte à partir des mesures réalisées par l'unité de mesure 4 pendant ladite période de mesure.

Selon des données fournies par les agences de l'eau et l'ADEME (*Agence de la transition écologique*), qui sont des établissements publics français, la consommation moyenne d'eau potable en France pour un ménage de quatre personnes est d'environ 120 litres par jour et par personne.

Même si la consommation d'eau varie considérablement en fonction des habitudes de chaque ménage et de son équipement (nombre de personnes, équipements sanitaires, appareils électroménagers, jardin, etc.), le profil de consommation présente systématiquement des zones de non-consommation.

Par non-consommation, on entend deux cas :

- pas de consommation (c'est-à-dire un débit nul) ;
- consommation stable (par exemple une petite fuite potentielle, qui est stable dans le temps).

La consommation typique journalière pour un appartement de deux personnes, représentée sur le graphique de la figure 2, montre que durant au moins 80% du temps, la variation de consommation est constante. Cette information est importante, car elle est le point d'entrée du procédé de transmission de mesures décrit ici.

Ce constat n'est pas surprenant, car les ménages ne consomment pas de manière continue. Une consommation continue est observée uniquement dans des cas particuliers (usine, fontaine d'eau, fuite d'eau).

Pour chaque période de mesure, l'unité de traitement 5 acquiert tout d'abord toutes les mesures réalisées par l'unité de mesure 4 au cours de ladite période de mesure.

Puis, l'unité de traitement 5 découpe chaque période de mesure en intervalles temporels.

L'unité de traitement 5 associe une donnée de mesure à chaque intervalle temporel, ladite donnée de mesure étant représentative d'une consommation de volume d'eau par l'installation 2 au cours dudit intervalle temporel.

Les données de mesure pourraient être des index cumulés absolus (comme pour la trame de mesures de l'Annexe 1).

Ici, cependant, pour chaque intervalle temporel (sauf pour le premier), la donnée de mesure est égale à la consommation par l'installation de la grandeur (volume d'eau) au cours dudit intervalle temporel. Ainsi, plutôt que d'envoyer des index cumulés absolus, l'unité de traitement 5 calcule la différence d'index entre deux moments, également appelée « delta index », c'est-à-dire l'index à l'instant « t » moins l'index à l'instant « t-1 ». De cette manière, la taille allouée pour chaque delta sera inférieure à celle allouée pour un index cumulé (4 octets par exemple pour l'index cumulé).

L'unité de traitement 5 alloue ensuite, à chaque donnée de mesure, une même taille de donnée obtenue à partir d'une valeur maximale des données de mesure sur ladite période de mesure.

La taille de donnée allouée est donc calculée de manière dynamique pour chaque journée en fonction des deltas de consommation. En calculant tous les deltas et en sélectionnant le maximum, on peut déterminer la taille à allouer, pour chaque delta, en fonction de cette valeur maximale.

L'unité de traitement 5 utilise la formule suivante :

$$taille\ de\ donnée$$
$$= nombre\ de\ bits\ alloués\ par\ intervalle\ temporel$$
$$= arrondi_{sup}\ (\ log_2(|Delta_{max}|)) + 1$$

où $Delta_{max}$ est la valeur maximale des données de mesure sur ladite période de mesure.

Ainsi, par exemple, si la valeur maximale des données de mesure sur une période de mesure est de 30 litres pour un pas de 5 minutes (intervalle temporel), alors l'unité de traitement 5 alloue 6 bits à chaque donnée de mesure (sauf à celle associée au premier intervalle temporel du jour, entre 00 :00 et 00 :05). Les 6 bits comprennent un bit de signe pour couvrir le cas du *backflow* (consommation « négative ») qui est pris en compte par certains fournisseurs d'eau. Le « + 1 » dans la formule ci-dessus permet de tenir compte du bit de signe.

Ainsi, la taille de la trame de collecte passe de 1152 octets à 220 octets, soit une réduction de 80% de la taille de la donnée utile.

La trame de collecte obtenue pourrait alors être semblable à celle de l'Annexe 2. La donnée de mesure associée au premier intervalle temporel a une taille de 4 octets, car elle contient l'index cumulé d'eau consommée.

Par contre, les autres données de mesures ont une taille de 6 bits.

Cependant, comme on vient de le voir, en se basant sur la consommation d'eau habituelle des ménages, on a observé que pendant 80% du temps, la différence de consommation est constante. Ces périodes correspondent à des moments où l'eau n'est généralement pas utilisée, comme le soir ou pendant les heures de travail. Cela correspond aussi à des débits de petites fuites constantes dans le temps.

Il est donc particulièrement avantageux de comprimer ces valeurs de différence constante afin de réduire encore plus la taille de la trame de collecte.

Ainsi, pour chaque période de mesure, l'unité de traitement 5 détecte, dans ladite période de mesure, au moins une période de consommation constante formée par des intervalles temporels successifs (au moins deux) au cours de chacun desquels la consommation est égale à une valeur constante. La figure 2 montre des périodes de consommation constante Pc.

Un jour comprend par exemple une période de consommation constante entre 01 :00 et 01 :20 (soit quatre intervalles temporels successifs), une autre période de consommation constante entre 04 :30 et 04 :55 (soit cinq intervalles temporels successifs), etc. Pour ces deux périodes de consommation constante, la consommation peut être nulle (valeur constante = 0 L), ou bien non nulle dans le cas d'une petite fuite constante.

Les périodes de consommation constante sont détectées dynamiquement et varient donc selon les périodes de mesure.

L'unité de traitement 5 produit alors et transmet une trame de collecte contenant les données de mesure associées aux intervalles temporels de la période de mesure, en remplaçant, pour chaque période de consommation constante, les données de mesure associées aux intervalles temporels successifs de ladite période de consommation constante par des données compactées comprenant au moins une première donnée permettant d'identifier lesdits intervalles temporels successifs de ladite période de consommation constante et une deuxième donnée contenant la valeur constante correspondant à ladite période de consommation constante.

Ici, les données compactées comprennent, pour chaque période de consommation constante identifiée :

- deux premières données permettant d'identifier les intervalles temporels successifs de ladite période de consommation constante. Ces premières données sont l'identifiant du premier intervalle temporel de la période de consommation constante (taille de la donnée : 2 octets), et le nombre d'intervalles temporels successifs de la période de consommation constante (taille de la donnée : 1 octet) ;
- une deuxième donnée contenant la valeur constante associée à la période de consommation constante, c'est-à-dire ici le delta d'index constant (taille de la donnée : 2 octets).

On obtient donc, pour chaque période de consommation constante, une métadonnée codée sur 5 octets.

Avantageusement, l'unité de traitement 5 vérifie, pour chaque période de consommation constante, qu'une taille des données compactées est bien inférieure à une taille des données de mesure associées aux intervalles temporels successifs de ladite période de consommation constante, et effectue le remplacement des données de mesure par les données compactées seulement si c'est le cas.

Ainsi, si la taille d'une métadonnée est supérieure à la zone à enlever, l'algorithme ne supprime pas la zone et garde les données de mesure de la zone.

Lorsque le SI 10 reçoit la trame de collecte, il commence par traiter les métadonnées pour obtenir les deltas originaux.

Avantageusement, l'unité de traitement 5 définit une durée optimale des intervalles temporels. La durée optimale est la plus petite durée qui permet de conserver une taille de la trame de collecte inférieure ou égale à une taille maximale prédéfinie. L'unité de traitement 5 découpe alors ladite période de mesure en intervalles temporels ayant pour durée la durée optimale, et produit la trame de collecte en utilisant des intervalles temporels ayant chacun pour durée la durée optimale.

Ainsi, selon les périodes de mesure, la durée des intervalles temporels peut varier. Plus les intervalles temporels sont de courte durée, plus la résolution des mesures collectées est élevée, mais plus la taille de la trame de collecte est importante.

La durée optimale est donc la durée la plus petite qui permet de conserver une taille de la trame de collecte inférieure ou égale à la taille maximale prédéfinie.

Dans le contexte où la taille maximale de la charge utile (*payload*) de la trame de mesure est limitée, un algorithme de compression est donc utilisé pour ajuster la résolution des mesures afin de maximiser le nombre d'index transmis tout en restant en dessous de cette limite fixée.

L'idée générale est que l'algorithme de compression peut itérer à travers les données à compresser et faire varier la résolution des mesures. L'algorithme peut alors évaluer le nombre d'index générés en utilisant différentes résolutions et sélectionner celle qui maximise le nombre d'index tout en garantissant que la taille totale de la charge utile reste en dessous de la limite spécifiée.

En ajustant la résolution des mesures de manière intelligente, l'algorithme peut trouver un compromis entre la précision des données et la taille de la charge utile.

On s'intéresse maintenant à la mise en œuvre de l'invention en décrivant deux processus : un processus de définition de la durée optimale des intervalles temporels, et un processus de calcul de la taille de la trame de collecte. Ces deux processus sont présentés séparément pour améliorer la compréhension du procédé.

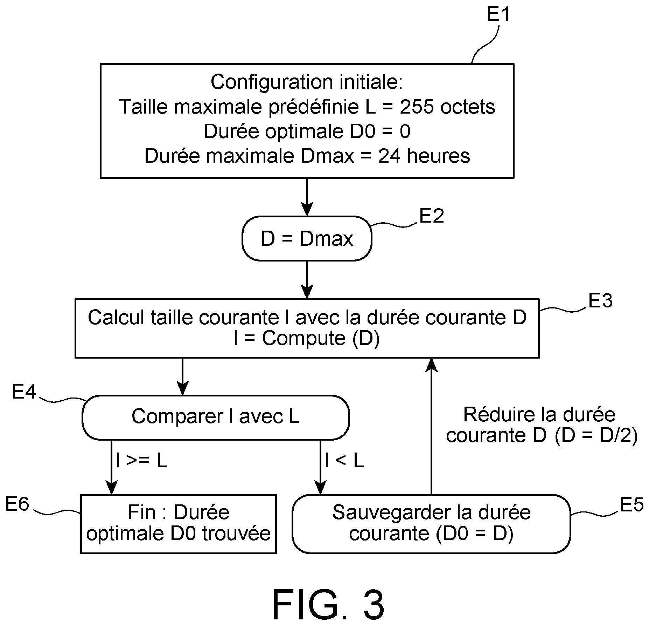

En référence à la figure 3, on présente tout d'abord un exemple d'algorithme utilisé pour mettre en œuvre le processus de définition de la durée optimale des intervalles temporels.

Ce processus utilise le processus de calcul de la taille d'une trame de collecte, qui sera décrit plus bas.

L'algorithme de la figure 3 permet de définir la durée optimale de chaque intervalle temporel pour la transmission de données en fonction d'une taille maximale prédéfinie L de la trame de collecte, qui est la taille à ne pas dépasser.

Par exemple, L = 255 octets.

L'algorithme utilise les variables :

- Durée courante D des intervalles temporels ;
- Taille courante 1 de la trame de collecte.

Le processus débute par une étape consistant à définir la configuration initiale : étape E1. La configuration initiale est définie avec les paramètres suivants.

La taille maximale prédéfinie est égale à L = 255 octets. La durée optimale D0 de chaque intervalle temporel est initialisée à 0. La durée maximale Dmax d'un intervalle temporel est de 24 heures.

Puis, la durée courante D est initialisée avec la valeur Dmax :

$$D = Dmax \ (\text{étape E2}).$$

L'unité de traitement 5 calcule alors la taille courante I de la trame de collecte en utilisant la durée courante D (étape E3). L'unité de traitement 5 utilise pour ce calcul le processus de calcul de la taille d'une trame de collecte qui sera décrit plus bas. On appelle ici « Compute (D) » cette fonction.

L'unité de traitement 5 compare alors la taille courante I de la trame de collecte avec la taille maximale prédéfinie L (étape E4).

Si la taille courante I est inférieure à la taille maximale prédéfinie L (ici strictement inférieure), l'unité de traitement 5 sauvegarde le durée courante D en tant que durée optimale D0 :

$$D0 = D \ (\text{étape E5}).$$

L'unité de traitement 5 réduit alors la durée courante D :

$$D = D/2.$$

Puis, le processus repasse à l'étape E3.

A l'étape E4, si la taille courante I est supérieure à la taille maximale prédéfinie L (ici supérieure ou égale), le processus se termine (étape E6). La durée optimale D0 a été identifiée.

Cet algorithme peut être mis en œuvre de la manière qui suit :

```
int main() {
    int L = 255;
    int Pmin = 1;      // Unité: minutes
    int Pmax = 24*60; // Unité: minutes
    int Po = 0;
    for (int P = Pmax; P >= Pmin; P /= 2) {
        int l = compute(P);
        if (l < L) {
            Po = P;
        } else {
            break;
        }
    }
    printf("La valeur optimale de Po est : %d\n", Po);
    return 0;
}
```

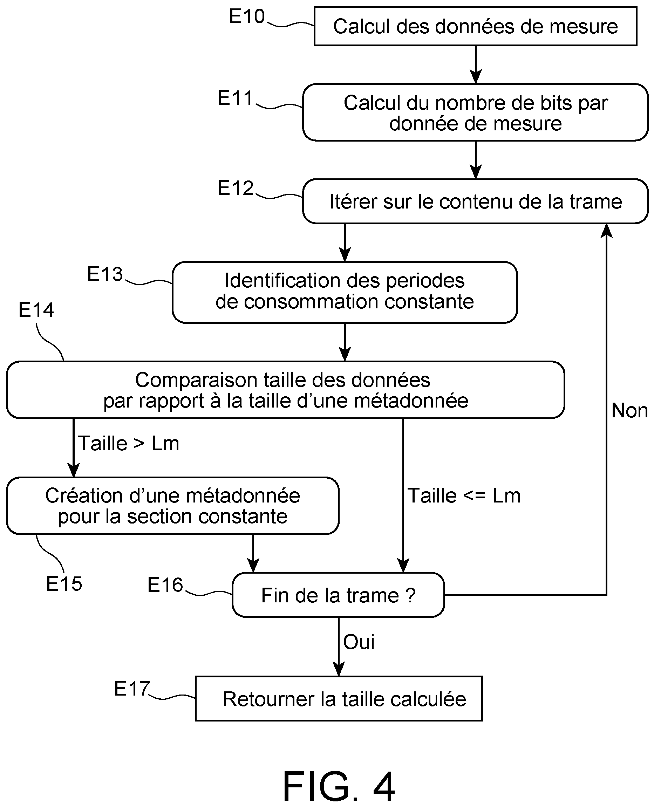

On décrit maintenant, en référence à la figure 4, un exemple d'algorithme utilisé pour mettre en œuvre le processus de calcul de la taille de la trame de collecte (« Compute (D) »). Ce processus permet aussi de produire la trame de collecte.

On utilise les opérations précédemment décrites : calcul des données de mesure, de la taille allouée à chaque donnée de mesure, et des métadonnées.

Le processus débute donc par le calcul des données de mesure, c'est-à-dire ici des variations de consommation entre les intervalles de mesure de la période de mesure (étape E10).

Puis, l'unité de traitement 5 calcule la taille de donnée allouée à chaque donnée de mesure, c'est-à-dire le nombre de bits nécessaire pour représenter chaque delta d'index (étape E11).

L'unité de traitement 5 itère alors sur le contenu de la trame de collecte et parcourt chaque élément de la trame de collecte pour effectuer les opérations de compression (étape E12).

L'unité de traitement 5 identifie les périodes de consommation constante (étape E13).

L'unité de traitement 5 produit pour chaque période de consommation constante les données compactées et compare la taille des données de mesure de chaque période de consommation constante avec la taille d'une métadonnée Lm (étape E14).

Si la taille des données de mesure de la période de consommation constante est supérieure (ici supérieure strictement) à la taille d'une métadonnée, l'unité de traitement 5 utilise bien ladite métadonnée pour produire la trame de collecte (étape E15).

L'unité de traitement 5 vérifie si le processus a atteint la fin de la trame de collecte (étape E16). Si ce n'est pas le cas, le processus repasse à l'étape E12.

Si c'est le cas, l'unité de traitement retourne la taille calculée de la trame de collecte (étape E17).

A l'étape E14, si la taille des données de mesure de la période de consommation constante est inférieure (ici inférieure ou égale) à la taille d'une métadonnée, l'unité de traitement 5 n'utilise pas la métadonnée et conserve les données de mesure de la période de consommation constante dans la trame de collecte. Le processus passe à l'étape E16.

L'invention permet donc de compresser les données de collecte afin de garder une haute résolution de mesure tout en réduisant la quantité de données à transmettre.

On réduit donc la quantité de données à transmettre tout en gardant une résolution suffisante. On maximise la quantité d'informations utiles dans une trame de collecte. On réduit l'impact énergétique des trames de collecte dans un compteur communiquant.

L'invention propose donc une méthode de compression adaptative de la trame de collecte afin de réduire sa taille tout en conservant les informations les plus importantes sur la consommation d'eau.

L'invention propose d'étudier les données d'index d'eau collectées par le compteur, calculer les deltas d'index et les compresser à l'aide d'un algorithme de compression approprié.

L'invention permet de maximiser la quantité d'informations utiles dans une trame de collecte donnée en ajustant, si besoin, le pas de mesure d'index.

L'implémentation de l'invention est très simple. Grâce à cette approche « sur mesure », elle permet d'obtenir un meilleur taux de conversion que les méthodes de compression standard.

Bien entendu, l'invention n'est pas limitée au mode de réalisation décrit mais englobe toute variante entrant dans le champ de l'invention tel que défini par les revendications.

Le procédé de transmission de mesures peut être mis en œuvre dans tout type de compteur : compteur de fluide (eau, gaz, pétrole, etc.), d'électricité, etc. Pour les compteurs électriques, la réduction de la consommation électrique desdits compteurs par la mise en œuvre du procédé n'est pas forcément très avantageuse, car ceux-ci sont généralement alimentés par le réseau de distribution d'électricité. Par contre, comme on l'a vu, le procédé permet aussi, en réduisant la taille des trames de collecte, de réduire l'encombrement du réseau de communication, ce qui est très avantageux même pour un compteur électrique.

Les périodes de mesure ne sont pas nécessairement des jours.

Les données de mesure ne sont pas nécessairement chacune égale à la consommation par l'installation de la grandeur au cours d'un intervalle temporel. Il pourrait s'agir d'une consommation cumulée. Dans ce cas, les données compactées peuvent comprendre des données qui identifient les intervalles temporels de la période de consommation constante, la valeur constante de consommation correspondant à ladite période de consommation constante, ainsi que la valeur de consommation au début du premier intervalle de la période de consommation constante.

### Annexe 1

format d'une trame de collecte

|  | Index cumulée (L) | Taille de l'index (octets) |
|---|---|---|
| Index @ 00 :00 | 12060 | 4 |
| Index @ 00 :05 | 12064 | 4 |
| Index @ 00 :10 | 12064 | 4 |
| … |  | .. |
| Index @ 23 :55 | 12 184 | 4 |

**Annexe 2**

format d'une trame de collecte avec delta index

|  | Index (L) | Taille (bits) |
|---|---|---|
| Index @ 00 :00 | 12060 | 4*8 |
| Delta Index @00 :05 - Index@ 00 :00 | 4 | 6 |
| Delta Index @00 :10 - Index@ 00 :05 | 30 | 6 |
| ... | ... | ... |
| Delta Index @23 :55 - Index@ 23 :50 | 2 | 6 |

**Revendications**

1. Procédé de transmission de mesures, mis en œuvre dans une unité de traitement (5) d'un compteur (1) agencé pour mesurer une grandeur consommée par une installation (2) au cours de périodes de mesure successives, comprenant les étapes, pour chaque période de mesure, de :

   - découper ladite période de mesure en intervalles temporels ;
   - associer une donnée de mesure à chaque intervalle temporel, ladite donnée de mesure étant représentative d'une consommation par l'installation (2) de la grandeur au cours dudit intervalle temporel ;

   **caractérisé en ce que** le procédé comprend en outre les étapes:

   - détecter, dans ladite période de mesure, au moins une période de consommation constante (Pc) formée par des intervalles temporels successifs au cours de chacun desquels la consommation est égale à une valeur constante ;
   - produire et transmettre une trame de collecte contenant les données de mesure associées aux intervalles temporels de la période de mesure, en remplaçant, pour chaque période de consommation constante (Pc), les données de mesure associées aux intervalles temporels successifs de ladite période de consommation constante par des données compactées comprenant au moins une première donnée permettant d'identifier lesdits intervalles temporels successifs de ladite période de consommation constante et une deuxième donnée contenant la valeur constante correspondant à ladite période de consommation constante.

2. Procédé de transmission de mesures selon la revendication 1, comprenant l'étape de vérifier, pour chaque période de consommation constante, qu'une taille des données compactées est inférieure à une taille des données de mesure associées aux intervalles temporels successifs de ladite période de consommation constante, et d'effectuer le remplacement des données de mesure par les données compactées seulement si c'est le cas.

3. Procédé de transmission de mesures selon l'une des revendications précédentes, comprenant en outre l'étape, pour chaque période de mesure, de définir une durée optimale des intervalles temporels, la durée optimale étant la plus petite durée qui permet de conserver une taille de la trame de collecte inférieure ou égale à une taille maximale prédéfinie, ladite période de mesure étant ensuite découpée en intervalles temporels ayant pour durée la durée optimale.

4. Procédé de transmission de mesures selon l'une des revendications précédentes, comprenant en outre l'étape d'allouer, à chaque donnée de mesure, une même taille de donnée obtenue à partir d'une valeur maximale des données de mesure sur ladite période de mesure.

5. Procédé de transmission de mesures selon l'une des revendications précédentes, dans lequel, pour chaque intervalle temporel, la donnée de mesure est égale à la consommation par l'installation de la grandeur au cours dudit intervalle temporel.

6. Compteur (1) comprenant une unité de communication (6) et une unité de traitement (5) agencée pour mettre en œuvre le procédé de transmission de mesures selon l'une des revendications précédentes, l'unité de communication étant agencée pour transmettre les trames de collecte à une entité externe (10) au compteur (1).

7. Compteur selon la revendication 6, le compteur étant un compteur de fluide.

8. Programme d'ordinateur comprenant des instructions qui conduisent l'unité de traitement (5) du compteur selon l'une des revendications 6 ou 7 à exécuter les étapes du procédé de transmission de mesures selon l'une des revendications 1 à 5.

9. Support d'enregistrement lisible par ordinateur, sur lequel est enregistré le programme d'ordinateur selon la revendication 8.

**Patentansprüche**

1. Verfahren zur Übertragung von Messwerten, welches in einer Verarbeitungseinheit (5) eines Zählers (1) ausgeführt wird, der dafür ausgelegt ist, eine während aufeinanderfolgender Messperioden von einer Anlage (2) verbrauchte Größe zu messen, umfassend die Schritte, dass in jeder Messperiode:

   - die jeweilige Messperiode in Zeitintervalle unterteilt wird;
   - jedem Zeitintervall ein Messdatenwert zugeordnet wird, wobei der Messdatenwert eine während des betreffenden Zeitintervalls von der Anlage (2) verbrauchte Größe darstellt;

   **dadurch gekennzeichnet, dass** das Verfahren ferner die Schritte umfasst, dass:

   - in der betreffenden Messperiode zumindest eine Periode mit konstantem Verbrauch (Pc) erkannt wird, die von aufeinanderfolgenden Zeitintervallen gebildet wird, in denen der Verbrauch jeweils einem konstanten Wert entspricht;
   - ein Sammelrahmen, welcher die den Zeitintervallen der betreffenden Messperiode zugeordneten Messdaten enthält, erzeugt und übertragen wird, indem für jede Periode mit konstantem Verbrauch (Pc) die den aufeinanderfolgenden Zeitintervallen der betreffenden Periode mit konstantem Verbrauch zugeordneten Messdaten durch komprimierte Daten ersetzt werden, welche umfassen: zumindest ein erstes Datenelement, das es erlaubt, die aufeinanderfolgenden Zeitintervalle der betreffenden Periode mit konstantem Verbrauch zu identifizieren, und ein zweites Datenelement, das den konstanten Wert enthält, welcher der betreffenden Periode mit konstantem Verbrauch zugeordnet ist.

2. Verfahren zur Übertragung von Messwerten nach Anspruch 1, umfassend den Schritt, dass für jede Periode mit konstantem Verbrauch überprüft wird, ob ein Volumen der komprimierten Daten kleiner ist als ein Volumen der Messdaten, welche aufeinanderfolgenden Zeitintervallen der betreffenden Periode mit konstantem Verbrauch zugeordnet sind, und dass die Ersetzung der Messdaten durch die komprimierten Daten nur dann durchgeführt wird, wenn dies der Fall ist.

3. Verfahren zur Übertragung von Messwerten nach einem der vorhergehenden Ansprüche, ferner umfassend den Schritt, dass für jede Messperiode eine optimale Dauer der Zeitintervalle definiert wird, wobei es sich bei der optimalen Dauer um die kürzeste Dauer handelt, die es erlaubt, ein Volumen des Sammelrahmens auf einem Niveau kleiner oder gleich einem vorgegebenen Maximalvolumen zu halten, wobei die Messperiode anschließend in Zeitintervalle unterteilt wird, welche jeweils die optimale Dauer aufweisen.

4. Verfahren zur Übertragung von Messwerten nach einem der vorhergehenden Ansprüche, ferner umfassend den Schritt, dass jedem Messdatenwert ein gleiches Datenvolumen zugewiesen wird, welches basierend auf einem über die betreffende Messperiode hinweg ermittelten Messdaten-Maximalwert gewonnen wurde.

5. Verfahren zur Übertragung von Messwerten nach einem der vorhergehenden Ansprüche, wobei für jedes Zeitintervall der Messdatenwert dem Größenverbrauch der Anlage während des betreffenden Zeitintervalls entspricht.

6. Zähler (1), umfassend eine Kommunikationseinheit (6) und eine Verarbeitungseinheit (5), die dafür ausgelegt ist, das Verfahren zur Übertragung von Messwerten nach einem der vorhergehenden Ansprüche auszuführen, wobei die Kommunikationseinheit dafür ausgelegt ist, die Sammelrahmen an eine externe Entität (10) außerhalb des Zählers (1) zu übertragen.

7. Zähler nach Anspruch 6, wobei es sich bei dem Zähler um einen Fluidzähler handelt.

8. Computerprogramm, das Befehle umfasst, welche die Verarbeitungseinheit (5) des Zählers nach einem der Ansprüche 6 oder 7 dazu veranlassen, die Schritte des Verfahrens zur Übertragung von Messwerten nach einem der Ansprüche 1 bis 5 auszuführen.

9. Computerlesbares Speichermedium, auf welchem das Computerprogramm nach Anspruch 8 abgespeichert ist.

**Claims**

1. A measurement transmission method, implemented in a processor module (5) of a meter (1) arranged to measure a quantity consumed by an installation (2) during successive measurement periods, comprising the steps, for each measurement period, of:

   - dividing said measurement period into time intervals;
   - associating a measurement data with each time interval, said measurement data being representative of a consumption by the installation (2) of the quantity during said time interval;

   **characterized in that** the method further comprises the steps of:

   - detecting, in said measurement period, at least one constant consumption period (Pc) formed by successive time intervals during each of which the consumption is equal to a constant value;
   - producing and transmitting a collection frame containing the measurement data associated with the time intervals of the measurement period, by replacing, for each constant consumption period (Pc), the measurement data associated with the successive time intervals of said constant consumption period with compacted data comprising at least a first data making it possible to identify said successive time intervals of said constant consumption period and a second data containing the constant value corresponding to said constant consumption period.

2. The measurement transmission method according to claim 1, comprising the step of verifying, for each constant consumption period, that a size of the compacted data is smaller than a size of the measurement data associated with the successive time intervals of said constant consumption period, and of carrying out the replacement of the measurement data by the compacted data only if this is the case.

3. The measurement transmission method according to any one of the preceding claims, further comprising the step, for each measurement period, of defining an optimum duration of the time intervals, the optimum duration being the shortest duration that makes it possible to maintain a size of the collection frame less than or equal to a predefined maximum size, said measurement period then being divided into time intervals having for duration the optimum duration.

4. The measurement transmission method according to any one of the preceding claims, further comprising the step of allocating, to each measurement data, a same size of data obtained from a maximum value of the measurement data over said measurement period.

5. The measurement transmission method according to any one of the preceding claims, wherein, for each time interval, the measurement data is equal to the consumption by the installation of the quantity during said time interval.

6. Meter (1) comprising a communication module (6) and a processor module (5) arranged to implement the measurement transmission method according to any one of the preceding claims, the communication module being arranged to transmit the collection frames to an entity (10) external to the meter (1) .

7. Meter according to claim 6, the meter being a fluid meter.

8. Computer program comprising instructions which cause the processor module (5) of the meter (1) according to any one of claims 6 or 7, to execute the steps of the measurement transmission method according to any one of claims 1 to 5.

9. Computer-readable recording medium, on which the computer program according to claim 8 is recorded.

FIG. 1

CONSOMMATION JOURNALIERE D'EAU
TYPIQUE POUR UN APPARTEMENT DE 2 PERSONNES

FIG. 2

E1

Configuration initiale:
Taille maximale prédéfinie L = 255 octets
Durée optimale D0 = 0
Durée maximale Dmax = 24 heures

E2

D = Dmax

E3

Calcul taille courante I avec la durée courante D
I = Compute (D)

E4

Comparer I avec L

Réduire la durée
courante D (D = D/2)

$I >= L$

$I < L$

E6

Fin : Durée
optimale D0 trouvée

E5

Sauvegarder la durée
courante (D0 = D)

# FIG. 3

E10 — Calcul des données de mesure

E11 — Calcul du nombre de bits par donnée de mesure

E12 — Itérer sur le contenu de la trame

E13 — Identification des periodes de consommation constante

E14 — Comparaison taille des données par rapport à la taille d'une métadonnée

Taille > Lm

Création d'une métadonnée pour la section constante

E15

E16 — Fin de la trame ?

Taille <= Lm

Non

Oui

E17 — Retourner la taille calculée

# FIG. 4

## RÉFÉRENCES CITÉES DANS LA DESCRIPTION

**Documents brevets cités dans la description**

- FR 3113219 A1

**Littérature non-brevet citée dans la description**

- **SPIEGEL JULIEN et al.** A Comparative Experimental Study of Lossless Compression Algorithms for Enhancing Energy Efficiency in Smart Meters. *2018 IEEE 16TH International Conference on Industrial Informatics(INDIN)*, July 2018, 447-452